# EUROPÄISCHE PATENTSCHRIFT

(11) **EP 4 381 544 B1**
(45) Veröffentlichungstag und Bekanntmachung des Hinweises auf die Patenterteilung: **03.09.2025**
(21) Anmeldenummer: 22757953.9
(22) Anmeldetag: 28.07.2022
(51) Int. Cl.: G01J 1/42, H10N 60/84, G01J 1/44

(54) **EINZELPHOTONENDETEKTORVORRICHTUNG ZUR DETEKTION EINES OPTISCHEN SIGNALS**
SINGLE PHOTON DETECTOR DEVICE FOR DETECTING AN OPTICAL SIGNAL
DISPOSITIF DE DÉTECTION DE PHOTONS INDIVIDUELS POUR LA DÉTECTION D'UN SIGNAL OPTIQUE

(30) Priorität: 02.08.2021 DE 102021119979
(43) Veröffentlichungstag der Anmeldung: 12.06.2024
(73) Patentinhaber: Pixel Photonics GmbH, 48149 Münster (DE)
(72) Erfinder: WALTER, Nicolai, 48151 Münster (DE); PERNICE, Wolfram, 48161 Münster (DE); BEUTEL, Fabian, 48161 Münster (DE); HARTMANN, Wladick, 48149 Münster (DE); WOLFF, Martin, 48143 Münster (DE)
(74) Vertreter: Pelster Behrends Patentanwälte PartG mbB
(86) Internationale Anmeldenummer: PCT/EP2022/071278
(87) Internationale Veröffentlichungsnummer: WO 2023/012039

(56) Entgegenhaltungen:
- GB-A- 2 588 330
- US-A1- 2019 189 816
- US-A1- 2020 333 179
- JAN PHILIPP HÖPKER ET AL: "Integrated superconducting nanowire single-photon detectors on titanium in-diffused lithium niobate waveguides", ARXIV.ORG, CORNELL UNIVERSITY LIBRARY, 201 OLIN LIBRARY CORNELL UNIVERSITY ITHACA, NY 14853, 26 April 2021 (2021-04-26), XP081944046

## Beschreibung

Die Erfindung betrifft eine Einzelphotonendetektorvorrichtung zur Detektion eines optischen Signals umfassend wenigstens einen optischen Wellenleiter und einen Nanodraht.

Wellenleiter-integrierte Superconducting-Photon-Detektoren und insbesondere deren Unterart Superconducting-Nanowire-Single-Photon-Detektoren (SNSPDs) detektieren hocheffizient breitbandiges Licht, das in einem Wellenleiter, auf dem sie integriert sind, propagiert. SNSPD weisen als eigentliches Detektorelement einen Nanodraht auf, der bei hinreichend tiefen Temperaturen supraleitend ist.

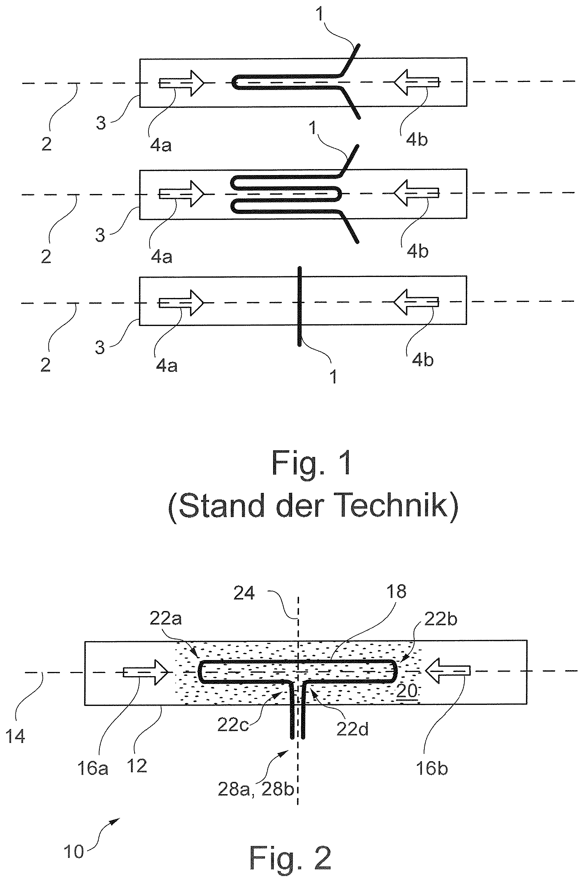

Beim im Stand der Technik bekannten SNSPDs, wie sie in Figur 1 dargestellt sind, erstreckt sich der Nanodraht 1 entweder in U-Form, oder W-Form entlang einer optischen Achse 2 des Wellenleiters 3. Durch die Erstreckung des Nanodrahtes 1 entlang der optischen Achse 2 ist die Absorption des im Wellenleiter 3 geführten Lichtes durch den Nanodraht 1 von dessen Länge abhängig, so dass die Absorption des Nanodrahtes 1 und somit die Effizienz des Detektors durch die Länge des Nanodrahtes 1 festgelegt werden kann. Diese Ausformungen haben allerding den Nachteil, dass die Effizienz des SNSPDs unterschiedlich ist, je nach dem aus welcher Richtung 4a, 4b das Licht im Wellenleiter 3 geführt wird.

Zudem sind im Stand der Technik SNSPDs mit I-förmigen Nanodrähten 1 bekannt, die sich senkrecht zur optischen Achse 2 erstrecken. Diese weisen aber aufgrund der Erstreckung senkrecht zur optischen Achse 2 nur eine sehr geringe Absorption auf, so dass diese SNSPDs keine hoch effiziente Detektion von Licht erlauben.

Die US 2020/333179 A1, die US 2019/189816 A1 und die GB 2588330 A offenbaren jeweils SNSPD und Verfahren zu deren Herstellung. Weiterer Stand der Technik ist in JAN PHILIPP HÖPKER ET AL: "Integrated superconducting nanowire single-photon detectors on titanium in-diffused lithium niobate waveguides",ARXIV.ORG, CORNELL UNIVERSITY LIBRARY, 26. April 2021 offenbart.

Ausgehend davon ist es Aufgabe der Erfindung, einen Einzelphotonendetektor bereitzustellen, dessen Unterschied in der Detektionseffizienz für Licht unterschiedlicher Propagationsrichtungen verringert ist. Insbesondere ist es Aufgabe der Erfindung einen Einzelphotonendetektor bereitzustellen, der Licht aus unterschiedlichen Propagationsrichtungen mit im Wesentlich äquivalent hoher Effizienz detektiert.

Diese Aufgabe wird durch die Merkmale des unabhängigen Patentanspruchs gelöst. Bevorzugte Weiterbildungen finden sich in den Unteransprüchen.

Erfindungsgemäß wird also eine Einzelphotonendetektorvorrichtung zur Detektion eines optischen Signals umfassend wenigstens einen optischen Wellenleiter und einen Nanodraht bereitgestellt, wobei die Einzelphotonendetektorvorrichtung eine SNSPD-Vorrichtung ist, wobei der wenigstens eine Wellenleiter dazu ausgestaltet ist, das optische Signal entlang einer optischen Achse in zwei einander entgegengesetzten Richtungen zu leiten, wobei der Nanodraht auf dem optischen Wellenleiter aufgebracht ist oder in den Wellenleiter integriert ist, oder im optischen Nahfeld des Wellenleiters nicht mehr als 1 µm vom optischen Wellenleiter entfernt zum optischen Wellenleiter angeordnet ist, wobei der Nanodraht innerhalb eines von dem wenigstens einen Wellenleiter definierten Bereichs wenigstens teilweise gekrümmt ist, und wobei der Nanodraht derart ausgeformt ist, dass der Nanodraht innerhalb des vom wenigstens einen Wellenleiter definierten Bereichs
a) bezogen auf eine senkrecht auf die optische Achse stehende Ebene im Wesentlichen spiegelsymmetrisch ist, oder
b) bezogen auf einen Punkt innerhalb des vom wenigstens einen Wellenleiter definierten Bereichs im Wesentlichen punktsymmetrisch ist,

wobei innerhalb des vom Wellenleiter definierten Bereichs Abweichungen von der Symmetrie von bis zu ± 5 % in jede Raumrichtung und/oder von bis zu ± 10 µm entlang der optischen Achse möglich sind,
dadurch gekennzeichnet, dass die Einzelphotonendetektorvorrichtung einen Koppler umfasst, wobei der Koppler mit zwei Enden des wenigstens einen Wellenleiters verbunden ist und derart ausgestaltet ist, dass ein optisches Signal in Abhängigkeit seiner Polarisation in unterschiedliche Enden des wenigstens einen Wellenleiters einkoppelbar ist, und wobei der Nanodraht in einem Bereich zwischen den zwei Enden des wenigstens einen Wellenleiters angeordnet ist.

Kern der Erfindung ist, den Nanodraht innerhalb des vom Wellenleiter definierten Bereichs in einer spezifischen Form aufweisend wenigstens eine Krümmung und eine im Wesentlichen spiegelsymmetrischen oder im Wesentlichen punktsymmetrischen Ausgestaltung auszuformen. Dies ermöglicht einerseits, dass die Einzelphotonendetektorvorrichtung das im Wellenleiter geführte optische Signal hocheffizient detektieren kann und anderseits, dass die Unterschiede der Effizienz, mit der die Einzelphotonendetektorvorrichtung das optische Signal in Abhängigkeit der Propagationsrichtung des optischen Signals detektiert, stark verringert sind. Besonders bevorzugt kann die Einzelphotonendetektorvorrichtung das optische Signal unabhängig von seiner Propagationsrichtung mit im Wesentlich gleicher Effizienz detektieren. In anderen Worten weist die Einzelphotonendetektorvorrichtung keine Vorzugsrichtung auf, in der das optische Signal mit höherer Effizienz detektiert wird, wie dies im Stand der Technik der Fall ist.

Der Wellenleiter der Einzelphotonendetektorvorrichtung ist derart ausgestaltet, dass das optische Signal entlang der optischen Achse des Wellenleiters propagieren kann. Dabei ist vorgesehen, dass das optische Signal in den zwei einander entgegengesetzten Richtungen entlang der optischen Achse propagieren kann. Beim optischen Wellenleiter handelt es sich bevorzugt um eine planare Lichtwellenleiterstruktur, die in der integrierten Optik verwendet wird. Der Nanodraht kann grundsätzlich auf dem optischen Wellenleiter aufgebracht sein, in den Wellenleiter integriert sein oder im optischen Nahfeld des Wellenleiters, bevorzugt nicht mehr als 1 µm vom optischen Wellenleiter entfernt, zum optischen Wellenleiter angeordnet sein. Besonders bevorzugt wird direkt bei Herstellung des Wellenleiters, der auf einem Chip geformt wird, der Nanodraht in die Wellenleiterstruktur integriert.

Der Nanodraht weist innerhalb des von dem wenigstens einen Wellenleiter definierten Bereichs eine spezifische Form auf. Mit vom Wellenleiter definierten Bereich ist im Sinne der Erfindung ein räumlicher Bereich gemeint, der in seinen Ausmaßen den Abmessungen des Wellenleiters entspricht. Beispielsweise kann sich der Nanodraht quer zur optischen Achse des Wellenleiters erstrecken und derart länger als die Breite des Wellenleiters sein, dass der Nanodraht an den Seiten des Wellenleiters übersteht. In diesem Beispiel liegt also ein Teil des Nanodrahtes, nämlich jener der den Wellenleiter kreuzt, innerhalb des vom Wellenleiter definierten Bereichs. Der Anteil des Nanodrahtes, der an den Seiten des Wellenleiters übersteht, liegt außerhalb des vom Wellenleiter definierten Bereichs.

Der Anteil des Nanodrahtes, der außerhalb des vom Wellenleiter definierten Bereichs liegt, kann eine beliebige Form annehmen. Der Anteil des Nanodrahtes der innerhalb des vom Wellenleiter definierten Bereichs liegt, ist wenigstens teilweise gekrümmt. Dies bedeutet, dass der Nanodraht in diesem Bereich zumindest eine Krümmung aufweist. Dies ermöglicht, dass der Nanodraht wenigstens teilweise parallel zur optischen Achse des Wellenleiters geführt werden kann, so dass die Einzelphotonendetektorvorrichtung eine sehr hohe Effizienz aufweist und schon sehr geringe optische Signale - bevorzugt im Bereich eines einzelnen Photons oder im Bereich weniger Photonen - detektieren kann.

Weiterhin ist vorgesehen, dass der Nanodraht innerhalb des vom Wellenleiter definierten Bereichs a) bezogen auf die senkrecht auf die optische Achse stehende Ebene im Wesentlichen spiegelsymmetrisch ist, oder b) dass der Nanodraht bezogen auf den Punkt innerhalb des vom Wellenleiter definierten Bereichs im Wesentlichen punktsymmetrisch ist, wobei innerhalb des vom Wellenleiter definierten Bereichs Abweichungen von der Symmetrie von bis zu ± 5 % in jede Raumrichtung und/oder von bis zu ± 10 µm entlang der optischen Achse möglich sind.

In Bezug zu a) ist die Form des Nanodrahtes innerhalb des vom Wellenleiter definierten Bereichs also derart, dass eine Spiegelebene senkrecht zur optischen Achse des Wellenleiters vorhanden ist, die die Form des Nanodrahtes innerhalb des vom Wellenleiter definierten Bereichs durch Spiegelung an der Spiegelebne auf sich selbst abbildet. Dabei sind allerdings Abweichungen von der Spiegel Symmetrie innerhalb zweier Toleranzbereiche möglich und zwar um bis zu ± 5 % in jede Raumrichtung und/oder von bis zu ± 10 µm entlang der optischen Achse. Bezogen auf den ersten Toleranzbereich bedeutet dies in anderen Worten, dass ein beliebiger Punkt des Nanodraht, um bis zu ± 5 % von dem durch die Spiegelsymmetrie vorgegeben Punkt abweichen kann und zwar in jede Raumrichtung. Die Prozentangabe bezieht sich dabei auf die Entfernung des Punktes senkrecht zur Spiegelebene. Wenn also beispielsweise ein Punkt des Nanodrahtes aufgrund der Spiegelsymmetrie 100 µm von der Spiegel ebene entfernt sein sollte, ermöglicht der erste Toleranzbereich, dass sich der entsprechende Punkt in einer Kugel mit Durchmesser von 5 µm (entspricht 5 % von 100 µm) um den durch die Spiegelsymmetrie vorgegebenen Punkt befinden kann. Unabhängig von diesem ersten Toleranzbereich kann ein beliebiger Punkt des Nanodraht um bis zu ± 10 µm von dem durch die Spiegelsymmetrie vorgegeben Punkt entlang der optischen Achse des Wellenleiters abweichen. Wenn also beispielsweise ein Punkt des Nanodrahtes aufgrund der Spiegelsymmetrie 150 µm von der Spiegel ebene entfernt sein sollte, ermöglicht der zweite Toleranzbereich, dass sich der entsprechende Punkt in einem Bereich von 140 µm bis 160 µm von der Spiegelebene entfernt befinden kann. Innerhalb dieser Abweichungen von der Spiegelsymmetrie ist es immer noch möglich, dass die Einzelphotonendetektorvorrichtung das optische Signal unabhängig von seiner Propagationsrichtung mit gleicher Effizienz detektieren kann.

In Bezug zu b) ist die Form des Nanodrahtes innerhalb des vom Wellenleiter definierten Bereichs also derart, dass ein Symmetriepunkt innerhalb des vom Wellenleiter definierten Bereichs vorhanden ist, der die Form des Nanodrahtes innerhalb des vom Wellenleiter definierten Bereichs durch Spiegelung an dem Symmetriepunkt auf sich selbst abbildet.

Auch dabei sind Abweichungen von der Punktsymmetrie innerhalb zweier Toleranzbereiche möglich und zwar um bis zu ± 5 % in jede Raumrichtung und/oder von bis zu ± 10 µm entlang der optischen Achse. Bezogen auf den ersten Toleranzbereich bedeutet dies in anderen Worten, dass ein beliebiger Punkt des Nanodraht, um bis zu ± 5 % von dem durch die Punktspiegelung vorgegeben Punkt abweichen kann und zwar in jede Raumrichtung. Die Prozentangabe bezieht sich dabei auf die Entfernung des Punktes zum Symmetriepunkt. Wenn also beispielsweise ein Punkt des Nanodrahtes aufgrund der Punktsymmetrie 100 µm vom Symmetriepunkt entfernt sein sollte, ermöglicht der erste Toleranzbereich, dass sich der entsprechende Punkt in einer Kugel mit Durchmesser von 5 µm (entspricht 5 % von 100 µm) um den durch die Punktsymmetrie vorgegebenen Punkt befinden kann. Unabhängig von diesem ersten Toleranzbereich kann ein beliebiger Punkt des Nanodraht um bis zu ± 10 µm von dem durch die Punktsymmetrie vorgegeben Punkt entlang der optischen Achse des Wellenleiters abweichen. Wenn also beispielsweise ein Punkt des Nanodrahtes aufgrund der Punktsymmetrie 150 µm vom Symmetriepunkt entfernt sein sollte, ermöglicht der zweite Toleranzbereich, dass sich der entsprechende Punkt in einem Bereich von ± 10 µm entlang der optischen Achse um den durch die Punktsymmetrie vorgegeben Punkt befinden kann. Innerhalb dieser Abweichungen von der Punktsymmetrie ist es immer noch möglich, dass die Einzelphotonendetektorvorrichtung das optische Signal unabhängig von seiner Propagationsrichtung mit gleicher Effizienz detektieren kann.

Beide Ausgestaltungen a) und b) ermöglichen, dass die Effizienzunterschiede, mit der die Einzelphotonendetektorvorrichtung das optische Signal in Abhängigkeit seiner Propagationsrichtung im Wellenleiter detektiert, stark verringert sind. Besonders bevorzugt ist die Detektionseffizienz unabhängig von der Propagationsrichtung des optischen Signals im Wellenleiter.

Im Hinblick auf Merkmal b) ist bevorzugt vorgesehen, dass der Punkt, also der Symmetriepunkt, innerhalb des vom Wellenleiter definierten Bereichs gleich weit von zwei Seiten des vom Wellenleiter definierten Bereichs beabstandet ist. In anderen Worten ist also bevorzugt vorgesehen, dass der Symmetriepunkt mittig in dem vom Wellenleiter definierten Bereich vorgesehen ist. Gemäß einer bevorzugten Weiterbildung der Erfindung ist vorgesehen, dass der Nanodraht nach Merkmal a) ausgeformt ist und dass zwei Enden des Nanodrahtes außerhalb des vom Wellenleiter definierten Bereichs auf der gleichen Seite des wenigstens einen Wellenleiters sind. Bevorzugt endet der Nanodraht also nicht innerhalb des vom Wellenleiter definierten Bereichs, sondern seine zwei Enden befinden sich außerhalb des vom Wellenleiter definierten Bereichs. Bevorzugt sind die zwei Enden des Nanodrahtes auf der gleichen Seite des Wellenleiters. Dies macht es besonders einfach die zwei Enden des Nanodrahtes mit jeweils einer Elektrode zu verbinden.

In diesem Zusammenhang ist gemäß einer weiteren bevorzugten Weiterbildung vorgesehen, dass der Nanodraht nach Merkmal b) ausgeformt ist und dass zwei Enden des Nanodrahtes außerhalb des vom Wellenleiter definierten Bereichs jeweils auf einander gegenüberliegenden Seiten des wenigstens einen Wellenleiters sind. Auch wenn der Nanodraht nach Merkmal b) ausgestaltet ist, ist bevorzugt vorgesehen, dass die Enden des Nanodrahtes sich nicht innerhalb des vom Wellenleiter definierten Bereichs befinden, sondern außerhalb. Zudem ist bevorzugt vorgesehen, dass die Enden des Nanodrahtes auf einander gegenüberliegenden Seiten des Wellenleiters sind. Bevorzugt ist in diesem Fall vorgesehen, dass die beiden Enden des Nanodrahtes bezogen auf die optische Achse im Wesentlichen an der gleichen Stelle sind. Dies vereinfacht das Anbringen von Elektroden und somit die Herstellung der Einzelphotonendetektorvorrichtung.

Der Nanodraht kann innerhalb des vom Wellenleiter definierten Bereichs grundsätzlich eine beliebige Form mit wenigstens einer Krümmung aufweisen, solange die Form entweder die beschriebene Spiegelsymmetrie oder Punktsymmetrie aufweist. In diesem Zusammenhang ist bevorzugt vorgesehen, dass der Nanodraht innerhalb des vom wenigstens einen Wellenleiter definierten Bereichs eine mäandrierende Form, eine S-Form und/oder eine ovale Form aufweist. Die S-Form ist ein Beispiel einer punktsymmetrischen Form, wobei die Enden des Nanodrahtes auf unterschiedlichen Seiten des Wellenleiters sind. Die ovale Form ist ein Beispiel einer spiegelsymmetrischen Form, wobei die Enden des Nanodrahtes auf der gleichen Seite des Wellenleiters sind. Vorliegend ist unter ovaler Form also nicht zu verstehen, dass die beiden Enden des Nanodrahtes sich innerhalb des vom Wellenleiter definierten Bereichs in einem Punkt treffen und ein geschlossenes Oval bilden, sondern dass zwei Endbereiche des Nanodrahtes, sich innerhalb des vom Wellenleiter definierten Bereichs räumlich derart nahe sind, dass der Nanodraht in seiner Form den Umfang eines geschlossenen Ovals zu wenigstens 75 % abdeckt.

Hinsichtlich des Toleranzbereiches und der S-Form kann also beispielsweise vorgesehen sein, dass eine erste Krümmung der S-Form bezogen auf eine senkrecht zur optischen Achse und durch den Symmetriepunkt verlaufende Bezugsachse, 10 µm weiter von dieser Bezugsachse entfernt ist als eine durch die Punktsymmetrie zu dieser ersten Krümmung korrespondierenden zweiten Krümmung der S-Form. Hinsichtlich des Toleranzbereiches und der ovalen Form kann beispielsweise vorgesehen sein, dass eine erste Krümmung der ovalen Form 10 µm näher bei der Spiegelebene liegt als die zur ersten Krümmung durch die Spiegelsymmetrie korrespondierenden zweiten Krümmung der ovalen Form.

Grundsätzlich ist es möglich, dass die Einzelphotonendetektorvorrichtung genau einen Wellenleiter und genau einen Nanodraht umfasst. Alternativ ist es möglich, dass die Einzelphotonendetektorvorrichtung eine Mehrzahl an Wellenleitern und genau einen Nanodraht umfasst. In diesem Zusammenhang ist gemäß einer bevorzugten Weiterbildung vorgesehen, dass die Einzelphotonendetektorvorrichtung eine Mehrzahl einander kreuzender Wellenleiter umfasst, wobei die Mehrzahl der Wellenleiter dazu ausgestaltet ist, das optische Signal entlang einer jeweiligen optischen Achse in zwei einander entgegengesetzten Richtungen zu leiten. Es kann also vorgesehen sein, dass genau ein Nanodraht für die Mehrzahl einander kreuzender Wellenleiter verwendet wird. Durch die Mehrzahl einander kreuzender Wellenleiter, die derart ausgestaltet sind, dass sie das optische Signal jeweils entlang ihrer optischen Achse in den zwei einander entgegengesetzten Richtungen leiten, weist die Einzelphotonendetektorvorrichtung somit mehr als zwei Propagationsrichtungen auf. Der Nanodraht ist bevorzugt derart ausgestaltet, dass das optische Signal in allen Propagationsrichtungen mit gleicher Effizienz detektierbar ist.

Weiterhin ist in diesem Zusammenhang gemäß einer bevorzugten Weiterbildung vorgesehen, dass der Nanodraht jeweils innerhalb des von jedem Wellenleiter definierten Bereichs gekrümmt ist, und dass der Nanodraht derart ausgeformt ist, dass der Nanodraht jeweils innerhalb des von jedem Wellenleiter definierten Bereichs bezogen auf eine senkrecht auf die optische Achse des jeweiligen Wellenleiters stehenden Ebene spiegelsymmetrisch ist, wobei innerhalb des vom jedem Wellenleiter definierten Bereichs jeweils Abweichungen von der Symmetrie von bis zu ± 5 % in jede Raumrichtung und/oder von bis zu ± 10 µm entlang der jeweiligen optischen Achse möglich sind. In anderen Worten ist also der Nanodraht über seine gesamte Läng betrachtet mehrmals gekrümmt und weist innerhalb jeden von einem Wellenleiter definierten Bereich die Spiegelsymmetrie auf.

Hinsichtlich der Enden des Nanodrahtes ist in Zusammenhang mit der Mehrzahl sich kreuzender Wellenleiter gemäß einer bevorzugen Weiterbildung der Erfindung vorgesehen, dass zwei Enden des Nanodrahtes jeweils auf der gleichen Seite eines jeden Wellenleiters der Mehrzahl an Wellenleitern ist. Die zwei Enden befinden sich also bevorzugt jeweils immer auf der gleichen Seite eines Wellenleiters, wobei dies für alle Wellenleiter gilt.

Weiterhin ist bevorzugt vorgesehen, dass der Nanodraht derart ausgeformt ist, dass der Nanodraht innerhalb aller von den jeweiligen Wellenleitern definierten Bereichen bezogen auf eine globale Spiegelebne im Wesentlichen spiegelsymmetrisch ist, wobei Abweichungen von der globalen Spiegelsymmetrie von bis zu ± 5 % in jede Raumrichtung und/oder von bis zu ± 10 µm entlang der jeweiligen optischen Achse des Wellenleiters möglich sind. Es ist also nicht nur bevorzugt vorgesehen, dass der Nanodraht nur lokal auf den von einem Wellenleiter definierten Bereich eine Spiegelsymmetrie zeigt, sondern auch, dass der Nanodraht in seiner Form, die der Nanodraht innerhalb aller von den Wellenleitern definierten Bereichen aufweist, eine Spiegelsymmetrie zeigt.

In Zusammenhang mit den sich kreuzenden Wellenleitern ist gemäß einer bevorzugten Weiterbildung der Erfindung vorgesehen, dass die Mehrzahl der Wellenleiter sich in einem gemeinsamen Bereich kreuzen. Beispielsweise bilden drei sich kreuzende Wellenleiter die Form eines Sterns. Derart können optische Signale aus einer Vielzahl an Propagationsrichtungen mit einem Nanodraht detektiert werden.

Eine Schwierigkeit für Einzelphotonendetektorvorrichtung umfassend wenigstens einen Wellenleiter und einen Nanodraht ist, dass das optische Signal in den Wellenleiter eingekoppelt werden muss. Die für die Einkopplung des optischen Signals verwendete Koppler weisen in der Regel unterschiedliche Effizienzen beim Einkoppeln für unterschiedlich polarisierte Anteile des optischen Signals auf. Entsprechend ist es, um einen möglichst hohen Anteil des optischen Signals in den Wellenleiter einzukoppeln, erforderlich, die Polarisation des optischen Signals vor dem Einkoppeln in den Wellenleiter zu kontrollieren, was zusätzliche optische Komponenten erfordert. In Zusammenhang mit dem Verzicht auf die Kontrolle der Polarisation des optischen Signals vor dem Einkoppeln in den Wellenleiter ist erfindungsgemäß vorgesehen, dass die Einzelphotonendetektorvorrichtung einen Koppler umfasst, wobei der Koppler mit zwei Enden des wenigstens einen Wellenleiters verbunden ist und derart ausgestaltet ist, dass das optische Signal in Abhängigkeit seiner Polarisation in unterschiedliche Enden des wenigstens einen Wellenleiters einkoppelbar ist, und wobei der Nanodraht in einem Bereich zwischen den zwei Enden des wenigstens einen Wellenleiters angeordnet ist. Dadurch dass die Einzelphotonendetektorvorrichtung das optische Signal unabhängig von seiner Propagationsrichtung mit gleicher Effizienz detektieren kann, kann mit einem Koppler, der das optische Signal in Abhängigkeit seiner Polarisation in die unterschiedlichen Enden des gleichen Wellenleiters einkoppelt, eine polarisationsunabhängige Einzelphotonendetektorvorrichtung bereitgestellt werden. Diese weist den Vorteil auf, dass bei Anwendungen mit einer hohen Anzahl an Kanälen, bei gleicher Effizienz für beide Polarisationsrichtungen des optischen Signals, die erforderliche Anzahl an Detektor reduziert werden kann, da lediglich eine polarisationsunabhängige Einzelphotonendetektorvorrichtung für beide Polarisationsrichtungen verwendet werden muss. Bevorzugt kann dabei vorgesehen sein, dass beim Nanodraht Abweichungen von der Spiegel Symmetrie oder Abweichungen von der Punktsymmetrie in den beschriebenen Toleranzbereichen verwendet werden, um unterschiedliche Absorptionen des Nanodrahtes in Bezug auf die beiden Polarisationsrichtungen zu kompensieren und derart das optische Signal unabhängig von seiner Propagationsrichtung mit gleicher Effizienz zu detektieren.

Erfindungsgemäß ist vorgesehen, dass der Nanodraht auf dem optischen Wellenleiter aufgebracht ist oder in den Wellenleiter integriert ist, oder im optischen Nahfeld des Wellenleiters nicht mehr als 1 µm vom optischen Wellenleiter entfernt zum optischen Wellenleiter angeordnet ist. Bevorzugt handelt es sich bei der Einzelphotonendetektorvorrichtung also um eine Einzelphotonendetektorvorrichtung, die mit gängigen Herstellungsverfahren aus der CMOS Industrie (complementary metal-oxidesemiconductor; Halbleiterprozess zur Fertigung von integrierten digitalen und/oder analogen Halbleiterbauelementen) realisierbar ist. Weiterhin ist bevorzugt vorgesehen, dass der Nanodraht einen im Wesentlichen rechteckigen Querschnitt aufweist, wobei die Dicke des Nanodrahts derart ist, dass ein supraleitender Strom durch den Nanodraht geleitet werden kann. Bevorzugt beträgt die Dicke des Nanodrahtes zwischen 3 nm und 20 nm. Weiter bevorzugt beträgt die Breite des Nanodrahts zwischen 10 nm und 2000 nm, bevorzugt zwischen 20 nm und 500 nm. Die Dicke des Nanodrahtes lässt sich während des Herstellungsprozesses durch die Dicke der supraleitenden Schicht, die abgeschieden wird, beeinflussen. Die Schicht kann nach dem Abscheiden beispielsweise durch Elektronenstrahllithografie und Plasma-unterstützte Ätzverfahren strukturiert werden, wobei dabei die Breite des Nanodrahts bestimmte werden kann. Zudem ist weiterhin bevorzugt vorgesehen, dass eine Länge des Nanodrahtes - gemessen von einem Ende des Nanodrahtes zu dem anderen Ende des Nanodrahtes - wenigstens um das Fünffache größer ist als die Breite des Nanodrahtes.

Hinsichtlich des Materials des Nanodrahtes ist bevorzugt vorgesehen, dass die Nanodrähte wenigstens eines der Materialien aus der Gruppe umfassend Nb, NbN, NbTi, NbTiN, Nb₃Ge, Nb₃Sn, SmFeAsO₁₋ₓFₓ, CeOFeAs, MgB₂, WₓSi₁₋ₓ MoRe, MoSi, TaN, Graphen, eisenhaltige Hochtemperatursupraleiter (Eisenpnictide), und Hochtemperatursupraleiter mit Kupferoxid insbesondere YBCO und/oder BSCCO umfassen. Der Nanodraht kann aus einem der Materialien oder aus mehreren Materialien in einer beliebigen Kombination bestehen. Er kann alternativ oder zusätzlich auch aus weiteren supraleitenden Materialien bestehen.

Nachfolgend wird die Erfindung unter Bezugnahme auf die Zeichnung anhand bevorzugter Ausführungsbeispiele exemplarisch erläutert.

In der Zeichnung zeigt
- Fig. 1: schematische Darstellungen von Einzelphotonendetektorvorrichtung wie im Stand der Technik bekannt,
- Fig. 2: eine schematische Darstellung einer Einzelphotonendetektorvorrichtung,
- Fig. 3: eine schematische Darstellung einer Einzelphotonendetektorvorrichtung,
- Fig. 4: eine schematische Darstellung einer Einzelphotonendetektorvorrichtung,
- Fig. 5: eine schematische Darstellung einer Einzelphotonendetektorvorrichtung mit einem Koppler, gemäß einer bevorzugten Ausführungsform der Erfindung, und
- Fig. 6: eine schematische Darstellung einer Einzelphotonendetektorvorrichtung.

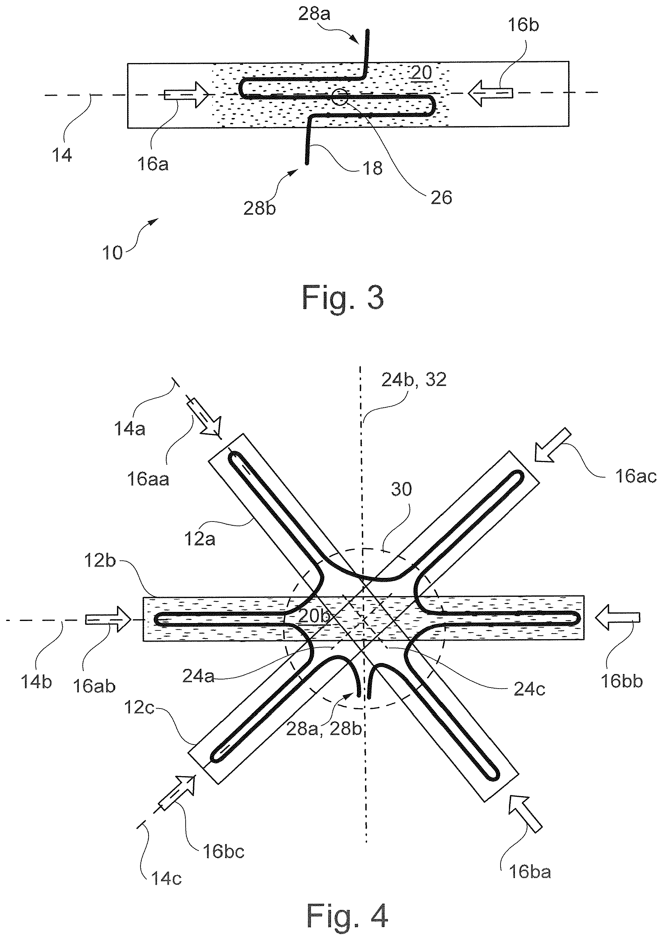

Figuren 2 und 3 zeigen schematische Darstellungen zweier Einzelphotonendetektorvorrichtung 10 zur Detektion eines optischen Signals. Die Einzelphotonendetektorvorrichtung 10 umfasst einen optischen Wellenleiter 12. Der Wellenleiter 12 ist dazu ausgestaltet das optische Signal entlang einer optischen Achse 14 in zwei einander entgegengesetzten Richtungen 16a, 16b zu leiten. Weiterhin umfasst die Einzelphotonendetektorvorrichtung 10 einen Nanodraht 18.

In beiden in den Figuren 2 und 3 gezeigten Einzelphotonendetektorvorrichtungen 10 ist der Nanodraht 18 innerhalb eines von dem Wellenleiter 12 definierten Bereichs 20 wenigstens teilweise gekrümmt. Wie in Figuren 2 und 3 ersichtlich, weist der Nanodraht 18 in beiden Einzelphotonendetektorvorrichtungen 10 innerhalb des vom Wellenleiter 12 definierten Bereichs 20 vier Krümmungen 22a, 22b, 22c, 22d auf.

Zudem ist der Nanodraht 18 in der in Figur 2 dargestellten Einzelphotonendetektorvorrichtung 10 derart ausgeformt, dass der Nanodraht 18 innerhalb des vom Wellenleiter 12 definierten Bereichs 20 bezogen auf eine senkrecht auf die optische Achse 14 stehenden Ebene 24 spiegelsymmetrisch ist. In anderen Worten bildet also die Spiegelebne 24 die Form des Nanodrahts 18 innerhalb des Bereichs 20 auf sich selbst ab. Vorliegend weist der Nanodraht 18 innerhalb des Bereichs 20 eine ovale Form auf.

In der in Figur 3 dargestellten Einzelphotonendetektorvorrichtung 10 ist der Nanodraht 18 derart ausgeformt, dass der Nanodraht 18 innerhalb des vom Wellenleiter 12 definierten Bereichs 20 bezogen auf einen Punkt 26 innerhalb des vom Wellenleiter 12 definierten Bereichs 20 punktsymmetrisch ist. In anderen Worten bildet also der Symmetriepunkt 26 die Form des Nanodrahts 18 innerhalb des Bereichs 20 auf sich selbst ab. Vorliegend mäandriert der Nanodraht 18 innerhalb des Bereichs 20 und weist die Form eines S auf.

In beiden gezeigten Einzelphotonendetektorvorrichtungen 10 sind zwei Enden 28a, 28b des Nanodrahtes 18 außerhalb des vom Wellenleiter 12 definierten Bereichs 20. In der Einzelphotonendetektorvorrichtung 10 in Figur 2 befinden sich die zwei Enden 28a, 28b auf der gleichen Seite des Wellenleiters 12. In der Einzelphotonendetektorvorrichtung 10 in Figur 3 befinden sich die zwei Enden 28a, 28b jeweils auf einander gegenüberliegenden Seiten des Wellenleiters 12, wobei bezogen auf die optische Achse 14, die beiden Enden 28a, 28b im Wesentlichen an der gleichen Stelle sind.

Figur 4 zeigt eine weitere Einzelphotonendetektorvorrichtung 10. In dieser Einzelphotonendetektorvorrichtung 10 weist die Einzelphotonendetektorvorrichtung 10 mehrere Wellenleiter 12a, 12b, 12c -- vorliegend drei - auf. Die drei Wellenleiter 12a, 12b, 12c kreuzen sich in einem Kreuzungsbereich 30. Jeder Wellenleiter 12a, 12b, 12c, ist derart ausgestaltet, dass er das optische Signal entlang seiner optischen Achse 14a, 14b, 14c (die übersichtshalber lediglich für den Wellenleiter 12b eingezeichnet ist) in den zwei einander entgegengesetzten Richtung 16a, 16b propagieren kann, so dass die Einzelphotonendetektorvorrichtung 10 insgesamt sechs Propagationsrichtungen, nämlich die Richtungen 16aa und 16ba für den Wellenleiter 12a, die Richtungen 16ab und 16bb für Wellenleiter 12b, und die Richtungen 16ac und 16bc für Wellenleiter 12c, vorweist. Zudem definiert jeder der Wellenleiter 12a, 12b, 12c einen Bereich 20a, 20b, 20c (der übersichtshalber nur für den Wellenleiter 12b dargestellt ist).

Der Nanodraht 18 ist vorliegend derart ausgeformt, dass der Nanodraht 18 jeweils innerhalb jedem der Bereiche 20a, 20b, 20c gekrümmt ist, und dass der Nanodraht 18 innerhalb jedem der Bereiche 20a, 20b, 20c bezogen auf eine senkrecht auf die jeweilige optische Achse 14a, 14b, 14c stehenden Ebene 24a, 24b, 24c spiegelsymmetrisch ist. Zudem ist der Nanodraht 18 im vorliegenden Beispiel derart ausgeformt, dass der Nanodraht 18 innerhalb aller Bereiche 20a, 20b, 20c bezogen auf eine globale Spiegel ebne 32, die vorliegend mit der Spiegelebne 24b zusammenfällt, spiegelsymmetrisch ist. Hinsichtlich der Enden 28a, 28b des Nanodrahtes 18, zeigt Figur 4, dass die zwei Enden 28a, 28b jeweils auf der gleichen Seite eines jeden Wellenleiters 12a, 12b, 12c sind.

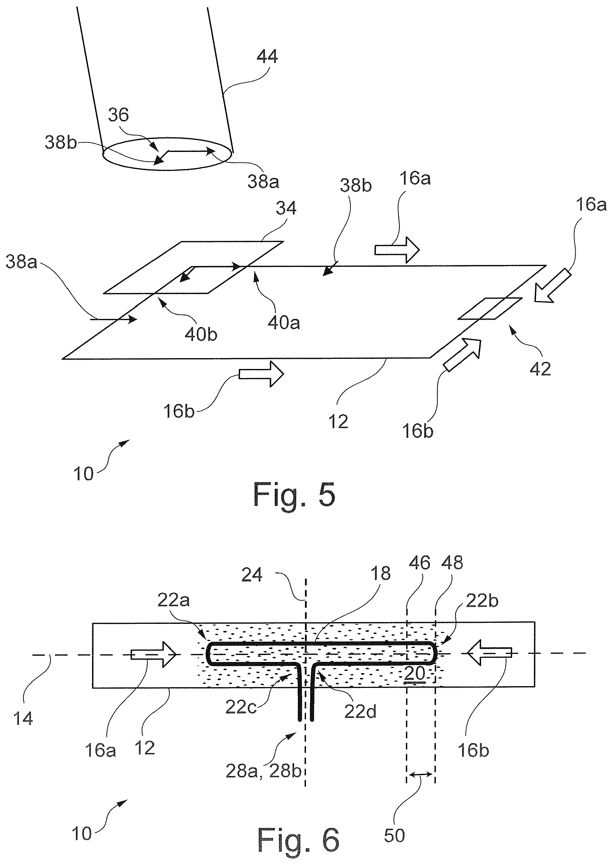

Figur 5 zeigt ein bevorzugtes Ausführungsbeispiel der erfindungsgemäßen Einzelphotonendetektorvorrichtung 10. In diesem Ausführungsbeispiel umfasst die Einzelphotonendetektorvorrichtung 10 einen Koppler 34. Der Koppler 34 ist derart ausgestaltet, dass das optische Signal 36, das zwei unterschiedlich polarisierte Anteile 38a, 38b umfasst, in Abhängigkeit der Polarisationsrichtung in unterschiedliche Enden 40a, 40b des Wellenleiters 12 einkoppelbar ist. Entsprechend ist der Koppler 34 mit den zwei Enden 40a, 40b des Wellenleiters 12 verbunden. Der Nanodraht 18 (selbst nicht in Figur 5 dargestellt) befindet sich in einem Bereich 42 zwischen den zwei Enden 40a, 40b des Wellenleiters 12. Zudem ist in Figur 5 eine Glasfaser 44 dargestellt, die das optische Signal 36 leitet, bevor es mittels des Kopplers 34 in den Wellenleiter 12 eingekoppelt wird. Dadurch dass die Einzelphotonendetektorvorrichtung 10 die in entgegengesetzten Richtungen 16a, 16b propagierenden Anteile 38a, 38b des optischen Signals 36 unabhängig von der Propagationsrichtung 16a, 16b mit gleicher Effizienz detektieren kann, zeigt Figur 5 eine polarisationsunabhängige Einzelphotonendetektorvorrichtung 10.

Figur 6 zeigt eine schematische Darstellung einer weiteren Einzelphotonendetektorvorrichtung 10 zur Detektion eines optischen Signals. Die Einzelphotonendetektorvorrichtung 10 ist wie in Figur 2 ausgestaltet, allerdings weist der Nanodraht 18 eine Abweichung von der Spiegelsymmetrie innerhalb eines Toleranzbereichs auf. Der Nanodraht 18 ist im von dem Wellenleiter 12 definierten Bereichs 20 wenigstens teilweise gekrümmt und im wesentlichen spiegelsymmetrisch ausgestaltet. Dabei ist in Figur 6 gut zu erkennen, dass die rechte Krümmung 22b des Nanodrahtes 18 nicht an dem über die Spiegelsymmetrie zum Ort der linken Krümmung 22a korrespondierenden Krümmungsort 46 ist, sondern versetzt dazu an dem Krümmungsort 48. Die beiden Krümmungsorte 46, 48 sind gemessen entlang der optischen Achse 14 vorliegend 10 µm voneinander beabstandet, was durch den Pfeil 50 symbolisiert ist.

### Bezugszeichenliste

- 1: Nanodraht (Stand der Technik)
- 2: optische Achse (Stand der Technik)
- 3: Wellenleiter (Stand der Technik)
- 4a, 4b: Propagationsrichtungen (Stand der Technik)

- 10: Einzelphotonendetektorvorrichtung
- 12: Wellenleiter
- 14: optische Achse
- 16a, 16b: Propagationsrichtungen
- 16aa, 16ba: Propagationsrichtung von Wellenleiter 12a
- 16ab, 16bb: Propagationsrichtung von Wellenleiter 12b
- 16ac, 16bc: Propagationsrichtung von Wellenleiter 12c
- 18: Nanodraht
- 20: vom Wellenleiter definierter Bereich
- 22: Krümmung
- 24: Spiegelebene
- 26: Symmetriepunkt
- 28a, 28b: Enden des Nanodrahts
- 30: Kreuzungsbereich
- 32: globale Spiegelebene
- 34: Koppler
- 36: optisches Signal
- 38a, 38b: Polarisierte Anteile des optischen Signals
- 40a, 40b: Enden des Wellenleiters
- 42: Bereich auf Wellenleiter
- 44: Glasfaser
- 46: durch Spiegelsymmetrie vorgegebener Krümmungsort
- 48: Krümmungsort
- 50: Abstand zwischen Krümmungsort 46 und Krümmungsort 48

## Patentansprüche

1. Einzelphotonendetektorvorrichtung (10) zur Detektion eines optischen Signals (36) umfassend wenigstens einen optischen Wellenleiter (12) **mit** zwei Enden (40a, 40b) und einen Nanodraht (18), wobei die Einzelphotonendetektorvorrichtung (10) eine SNSPD-Vorrichtung ist,
wobei der wenigstens eine Wellenleiter (12) dazu ausgestaltet ist, das optische Signal (36) entlang einer optischen Achse (14) in zwei einander entgegengesetzten Richtungen (16a, 16b) zu leiten,
wobei der Nanodraht (18) auf dem optischen Wellenleiter (12) aufgebracht ist oder in den Wellenleiter (12) integriert ist, oder im optischen Nahfeld des Wellenleiters (12) nicht mehr als 1 µm vom optischen Wellenleiter (12) entfernt zum optischen Wellenleiter (12) angeordnet ist, wobei der Nanodraht (18) innerhalb eines von dem wenigstens einen Wellenleiter (12) definierten Bereichs (20) wenigstens teilweise gekrümmt ist, und
wobei der Nanodraht (18) derart ausgeformt ist, dass der Nanodraht (18) innerhalb des vom wenigstens einen Wellenleiter (12) definierten Bereichs (20)
a) bezogen auf eine senkrecht auf die optische Achse (14) stehenden Ebene (24) im Wesentlichen spiegelsymmetrisch ist, oder
b) bezogen auf einen Punkt (26) innerhalb des vom wenigstens einen Wellenleiter (12) definierten Bereichs (20) im Wesentlichen punktsymmetrisch ist,
wobei innerhalb des vom Wellenleiter (12) definierten Bereichs (20) Abweichungen (50) von der Symmetrie von bis zu ± 5 % in jede Raumrichtung und/oder von bis zu ± 10 µm entlang der optischen Achse (14) möglich sind,
**dadurch gekennzeichnet, dass** die Einzelphotonendetektorvorrichtung (10) einen Koppler (34) umfasst, wobei der Koppler (34) mit **den** zwei Enden (40a, 40b) des wenigstens einen Wellenleiters (12) verbunden ist und derart ausgestaltet ist, dass ein optisches Signal (36) in Abhängigkeit seiner Polarisation (38a, 38b) in unterschiedliche Enden (40a, 40b) des wenigstens einen Wellenleiters (12) einkoppelbar ist, und wobei der Nanodraht (18) in einem Bereich (42) zwischen den zwei Enden (40a, 40b) des wenigstens einen Wellenleiters (12) angeordnet ist.

2. Einzelphotonendetektorvorrichtung (10) nach Anspruch 1, wobei der Nanodraht (18) nach Merkmal a) ausgeformt ist und wobei zwei Enden (28a, 28b) des Nanodrahtes (18) außerhalb des vom Wellenleiter (12) definierten Bereichs (20) auf der gleichen Seite des wenigstens einen Wellenleiters (12) sind.

3. Einzelphotonendetektorvorrichtung (10) nach Anspruch 1, wobei der Nanodraht (18) nach Merkmal b) ausgeformt ist und wobei zwei Enden (28a, 28b) des Nanodrahtes (18) außerhalb des vom Wellenleiter (12) definierten Bereichs (20) jeweils auf einander gegenüberliegenden Seiten des wenigstens einen Wellenleiters (12) sind.

4. Einzelphotonendetektorvorrichtung (10) nach einem der vorhergehenden Ansprüche, wobei der Nanodraht (18) innerhalb des vom wenigstens einen Wellenleiter (12) definierten Bereichs (20) eine mäandrierende Form, eine S-Form und/oder eine ovale Form aufweist.

## Claims

1. Single photon detector device (10) for detecting an optical signal (36), comprising at least one optical waveguide (12) with two ends (40a, 40b) and a nanowire (18), wherein the single photon detector device (10) is a SNSPD device,
wherein the at least one waveguide (12) is designed to guide the optical signal (36) along an optical axis (14) in two mutually opposite directions (16a, 16b), wherein the nanowire (18) is applied on the optical waveguide (12) or is integrated into the waveguide (12) or is arranged in the optical near field of the waveguide (12) not more than 1 µm away from the optical waveguide (12),
wherein the nanowire (18) is at least partly curved within a region (20) defined by the at least one waveguide (12), and
wherein the nanowire (18) is shaped in such a way that within the region (20) defined by the at least one waveguide (12) the nanowire (18)
a) is substantially mirror-symmetrical relative to a plane (24) perpendicular to the optical axis (14), or
b) is substantially point-symmetrical relative to a point (26) within the region (20) defined by the at least one waveguide (12),
wherein within the region (20) defined by the waveguide (12) deviations (50) from symmetry of up to ± 5% in each spatial direction and/or of up to ± 10 µm along the optical axis (14) are possible
**characterized in that** the single photon detector device (10) comprises a coupler (34), wherein the coupler (34) is connected to the two ends (40a, 40b) of the at least one waveguide (12) and is designed in such a way that an optical signal (36) can be coupled into different ends (40a, 40b) of the at least one waveguide (12) depending on its polarization (38a, 38b), and wherein the nanowire (18) is arranged in a region (42) between the two ends (40a, 40b) of the at least one waveguide (12).

2. Single photon detector device (10) as claimed in claim 1, wherein the nanowire (18) is shaped according to feature a) and wherein two ends (28a, 28b) of the nanowire (18) outside the region (20) defined by the waveguide (12) are on the same side of the at least one waveguide (12).

3. Single photon detector device (10) as claimed in claim 1, wherein the nanowire (18) is shaped according to feature b) and wherein two ends (28a, 28b) of the nanowire (18) outside the region (20) defined by the waveguide (12) are each on mutually opposite sides of the at least one waveguide (12).

4. Single photon detector device (10) as claimed in any of the preceding claims, wherein within the region (20) defined by the at least one waveguide (12) the nanowire (18) has a meandering shape, an S-shape and/or an oval shape.

## Revendications

1. Dispositif détecteur de photons individuels (10) pour détecter un signal optique (36), comprenant au moins un guide d'onde (12) optique à deux extrémités (40a, 40b) et un nanofil (18), ledit dispositif détecteur de photons individuels (10) étant un dispositif SNSPD,
ledit au moins un guide d'onde (12) étant conçu pour guide le signal optique (36) le long d'un axe optique (14) dans deux sens opposés l'un de l'autre (16a, 16b),
le nanofil (18) étant fixé sur le guide d'onde (12) optique ou intégré dans le guide d'onde (12) optique, ou agencé dans le champ optique à proximité du guide d'onde (12), à une distance du guide d'onde (12) optique inférieure ou égale à 1 µm du guide d'onde (12) optique, le nanofil (18) étant au moins partiellement courbé à l'intérieur d'une zone (20) définie par ledit au moins un guide d'onde (12), et
le nanofil (18) étant formé de telle sorte que ledit nanofil (18) est, à l'intérieur de la zone (20) définie par ledit au moins un guide d'onde (12),
a) sensiblement en symétrie spéculaire par rapport à un plan (24) perpendiculaire à l'axe optique (14), ou
b) sensiblement en symétrie ponctuelle par rapport à un point (26) situé à l'intérieur de la zone (20) définie par ledit au moins un guide d'onde (12),
des écarts (50) de symétrie de jusqu'à ± 5 % dans chaque direction spatiale, et/ou de jusqu'à ± 10 µm le long de l'axe optique (14), étant possibles à l'intérieur de la zone (20) définie par le guide d'onde (12),
**caractérisé en ce que** le dispositif détecteur de photons individuels (10) comprend un coupleur (34), ledit coupleur (34) étant relié aux deux extrémités (40a, 40b) dudit au moins un guide d'onde (12), et conçu de telle sorte qu'un signal optique (36) peut être couplé à des extrémités différentes (40a, 40b) dudit au moins guide d'onde (12) en fonction de sa polarisation (38a, 38b), et le nanofil (18) étant agencé dans une zone (42) située entre les deux extrémités (40a, 40b) dudit au moins un guide d'onde (12).

2. Dispositif détecteur de photons individuels (10) selon la revendication 1, le nanofil (18) étant formé selon la caractéristique a) et les deux extrémités (28a, 28b) du nanofil (18) se trouvant, à l'extérieur de la zone (20) définie par le guide d'onde (12), sur le même côté dudit au moins un guide d'onde (12).

3. Dispositif détecteur de photons individuels (10) selon la revendication 1, le nanofil (18) étant formé selon la caractéristique b) et les deux extrémités (28a, 28b) du nanofil (18) se trouvant, à l'extérieur de la zone (20) définie par le guide d'onde (12), chacune sur des côtés dudit au moins un guide d'onde (12) opposés l'un à l'autre.

4. Dispositif détecteur de photons individuels (10) selon l'une quelconque des revendications précédentes, le nanofil (18) présentant, à l'intérieur de la zone (20) définie par ledit au moins guide d'onde (12), une forme en méandres, une forme en S et/ou une forme ovale.
